# EUROPEAN PATENT SPECIFICATION

(11) **EP 3 422 504 B1**
(45) Date of publication and mention of the grant of the patent: **12.02.2020**
(21) Application number: 16891439.8
(22) Date of filing: 24.02.2016
(51) Int. Cl.: H02B 13/065, G01R 31/12, H01C 7/12, H02H 3/04, H02H 9/04

(54) **MONITORING SYSTEM AND MONITORING METHOD**
ÜBERWACHUNGSSYSTEM UND ÜBERWACHUNGSVERFAHREN
SYSTÈME ET PROCÉDÉ DE SURVEILLANCE

(43) Date of publication of application: 02.01.2019
(73) Proprietor: Mitsubishi Electric Corporation, Chiyoda-ku Tokyo 100-8310 (JP)
(72) Inventor: FUJII, Shigeo, Tokyo 100-8310 (JP)
(74) Representative: Zech, Stefan Markus
(86) International application number: PCT/JP2016/055386
(87) International publication number: WO 2017/145282

(56) References cited:
- JP-A- H 042 077
- JP-A- H0 246 129
- JP-A- H04 206 375
- JP-A- 2000 125 461
- JP-A- 2014 176 240
- JP-A- 2015 158 455
- KR-A- 20070 074 321

## Description

### Field

The present invention relates to a monitoring system and a monitoring method for monitoring degradation or breakage of a lightning arrester having been struck by lightning.

### Background

A conventional monitoring system that monitors degradation or breakage of a lightning arrester calculates the amount of lightning strike energy received by a gas-insulated lightning arrester having been struck by lightning based on the temperature or pressure within a tank filled with insulating gas. The monitoring system determines the degree of degradation or breakage of the lightning arrester based on the calculated amount of lightning strike energy. The following prior art documents disclose gas-insulated lightning arrester diagnostic systems: JPH04206375, JPH042077 and KR20070074321.

### Citation List

### Patent Literature

Patent Literature 1: Japanese Patent Application Laid-open No. 2015-158455

### Summary

### Technical Problem

The conventional monitoring system described above takes into account the temperature or pressure within the tank upon occurrence of a lightning strike, but does not take into account the influence of change of outside-air temperature on the calculation. Thus, there is a problem in that the calculated amount of lightning strike energy may be different from the actual amount of lightning strike energy.

The present invention has been achieved to solve the above problems, and an object of the present invention is to provide a monitoring system that can monitor a gas-insulated lightning arrester based on the amount of lightning strike energy which is calculated more accurately.

### Solution to Problem

In order to solve the above problems and achieve the object, a monitoring system according to the present invention monitors a plurality of gas-insulated lightning arresters, each of which is provided with a lightning arrester element within a tank filled with insulating gas, and comprises an internal-value detection unit to detect an internal value that indicates a temperature or a pressure inside the tank. The monitoring system further comprises: a lightning-strike detection unit to detect that the gas-insulated lightning arrester has been struck by lightning based on the detected internal value; an effective-value calculation unit to calculate an effective internal value by subtracting an internal value within a tank of a gas-insulated lightning arrester, determined not to have been struck by lightning, among the gas-insulated lightning arresters from an internal value within a tank of a gas-insulated lightning arrester, determined to have been struck by lightning, among the gas-insulated lightning arresters; and an energy calculation unit to calculate an amount of lightning strike energy the gas-insulated lightning arrester incurred based on the effective internal value.

### Advantageous Effects of Invention

According to the monitoring system of the present invention, there is an effect where it is possible to monitor a gas-insulated lightning arrester based on the amount of lightning strike energy which is calculated more accurately.

### Brief Description of Drawings

FIG. 1 is a configuration diagram of a monitoring system according to a first embodiment of the present invention.
FIG. 2 is a diagram illustrating a functional configuration of a detection device according to the first embodiment.
FIG. 3 is a diagram illustrating a change of gas pressure in a tank of a gas-insulated lightning arrester which has been struck by lightning according to the first embodiment.
FIG. 4 is a diagram illustrating a change of gas pressure in the tank of the gas-insulated lightning arrester which has been struck by lightning, and a change of gas pressure in a tank of a gas-insulated lightning arrester which has not been struck by lightning according to the first embodiment.
FIG. 5 is a diagram illustrating a hardware configuration of the detection device according to the first embodiment.
FIG. 6 is a flowchart illustrating a procedure for determining whether a lightning arrester element is degraded or broken in the monitoring system according to the first embodiment.
FIG. 7 is a configuration diagram of a monitoring system according to a second embodiment of the present invention.
FIG. 8 is a diagram illustrating a functional configuration of a detection device according to the second embodiment.
FIG. 9 is a configuration diagram of a monitoring system according to a third embodiment of the present invention.
FIG. 10 is a configuration diagram of a monitoring system according to a modification of the third embodiment.

### Description of Embodiments

A monitoring system and a monitoring method according to embodiments of the present invention will be described in detail below with reference to the accompanying drawings. The present invention is not limited to the embodiments.

### First embodiment.

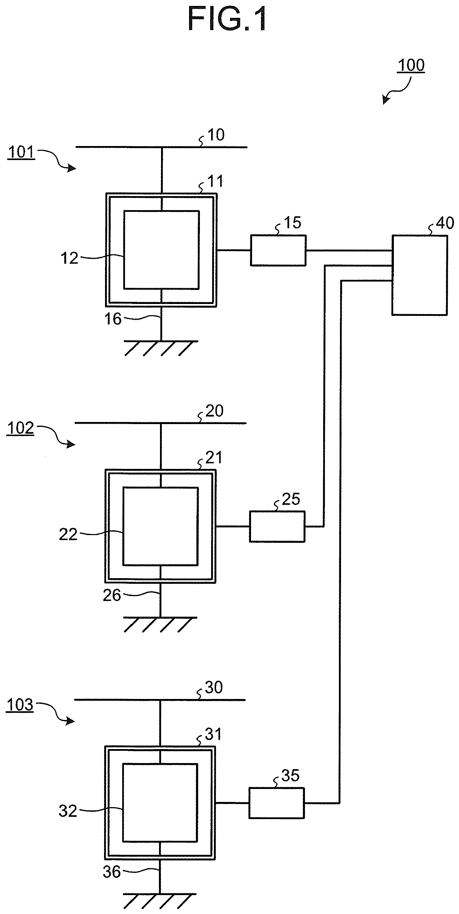

FIG. 1 is a configuration diagram of a monitoring system according to a first embodiment of the present invention. A monitoring system 100 includes: gas-insulated lightning arresters 101, 102, and 103; sensors 15, 25, and 35; and a detection device 40. The gas-insulated lightning arresters 101, 102, and 103 include tanks 11, 21, and 31 and Lightning Arrester (LA) elements 12, 22, and 32, respectively. The tanks 11, 21, and 31 are hermetically-sealed metallic containers. The tanks 11, 21, and 31 are filled with insulating gas, typically, SF₆.

The LA elements 12, 22, and 32 are provided in the tanks 11, 21, and 31, respectively. One end of the LA elements 12, 22, and 32 is connected to high-voltage conductors 10, 20, and 30, respectively. The other end of the LA elements 12, 22, and 32 is connected to the ground through ground wires 16, 26, and 36, respectively.

As described above, in a three-phase power system, it is common that a gas-insulated lightning arrester is provided for each of the three phases. The sensors 15, 25, and 35 as internal-value detection units are provided respectively for the gas-insulated lightning arresters 101, 102, and 103. The sensors 15, 25, and 35 detect the pressure within the respective tanks 11, 21, and 31 as an internal value. The pressures detected by the sensors 15, 25, and 35 are input to the detection device 40. In the following descriptions, the pressure within the tanks 11, 21, and 31 is referred to as "gas pressure".

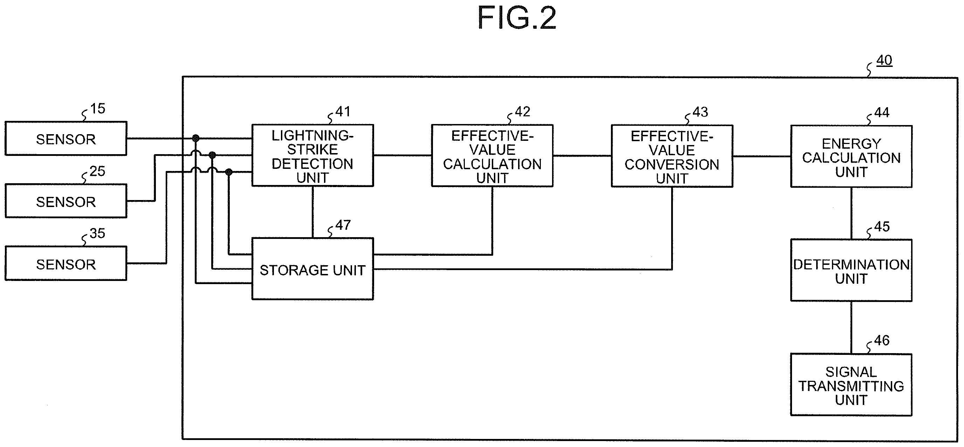

FIG. 2 is a diagram illustrating a functional configuration of the detection device 40 according to the first embodiment. The detection device 40 includes a lightning-strike detection unit 41, an effective-value calculation unit 42, an effective-value conversion unit 43, an energy calculation unit 44, a determination unit 45, a signal transmitting unit 46, and a storage unit 47.

The lightning-strike detection unit 41 detects that a lightning strike has occurred on the high-voltage conductor 10, 20, 30 based on the gas pressure within the tank 11, 21, 31 input from the sensor 15, 25, 35. When any of the high-voltage conductors 10, 20, and 30 is struck by lightning, there is an increase in the temperature of the corresponding LA element 12, 22, or 32 in the gas-insulated lightning arrester 101, 102, or 103 connected to the high-voltage conductor 10, 20, or 30 having been struck by lightning. As the temperature of the LA element 12, 22, or 32 increases, the temperature of ambient insulating gas, that is, the temperature of insulating gas within the tank 11, 21, or 31 also increases. Because the inside of the tank 11, 21, 31 is an enclosed space, as the insulating-gas temperature increases, the gas pressure in the tank 11, 21, 31 increases. That is, the high-voltage conductor 10, 20, 30 connected to the gas-insulated lightning arrester 101, 102, 103 with an increased gas pressure can be determined as the high-voltage conductor 10, 20, 30 having been struck by lightning. In the following descriptions, the phrase "the high-voltage conductor 10, 20, 30 is struck by lightning" is also sometimes rephrased as "the gas-insulated lightning arrester 101, 102, 103 is struck by lightning".

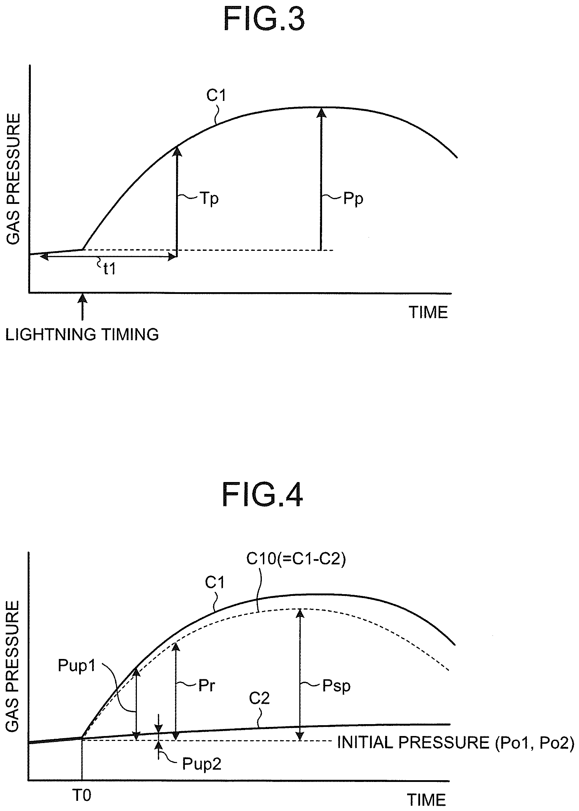

FIG. 3 is a diagram illustrating a change of gas pressure in the tank 11, 21, 31 of the gas-insulated lightning arrester 101, 102, 103 which has been struck by lightning according to the first embodiment. The lightning-strike detection unit 41 calculates a difference Tp which is a difference between a gas pressure of a last cycle and a gas pressure of a current cycle input from the sensor 15, 25, 35 in a given cycle t1. When the difference Tp of gas pressures exceeds a predetermined threshold, the lightning-strike detection unit 41 determines that a lightning strike has occurred on the gas-insulated lightning arrester 101, 102, 103 which corresponds to the phase of the sensor 15, 25, 35 having detected the excessive gas pressure. The threshold to be used for determining whether a lightning strike has occurred is stored in the storage unit 47. The lightning-strike detection unit 41 inputs a signal indicating the gas-insulated lightning arrester 101, 102, or 103 that has been struck by lightning to the effective-value calculation unit 42.

FIG. 4 is a diagram illustrating a change of gas pressure in the tank 11, 21, 31 of the gas-insulated lightning arrester 101, 102, 103 which has been struck by lightning, and a change of gas pressure in the tank 11, 21, 31 of the gas-insulated lightning arrester 101, 102, 103 which has not been struck by lightning according to the first embodiment. The storage unit 47 stores therein gas pressures measured in a given time period including before and after a time point at which a gas-insulated lightning arrester is determined to have been struck by lightning. The gas pressures stored in the storage unit 47 refer to gas pressures of all the gas-insulated lightning arresters 101, 102, and 103 regardless of whether the gas-insulated lightning arrester 101, 102, 103 has been struck by lightning. That is, the storage unit 47 stores therein a gas-pressure change curve C1 of the gas-insulated lightning arrester 101, 102, 103 which has been struck by lightning, and a gas-pressure change curve C2 of the gas-insulated lightning arrester 101, 102, 103 which has not been struck by lightning. In the following descriptions, a time point at which a gas-insulated lightning arrester is determined to have been struck by lightning is referred to as "lightning time T0". Further, a gas pressure of the gas-insulated lightning arrester 101, 102, 103 at the lightning time T0 is referred to as "initial pressure".

Referring to the gas-pressure change curve C2 of the gas-insulated lightning arrester 101, 102, 103 which has not been struck by lightning, the gas pressure increases as time elapses in spite of not having been struck by lightning. Several tens of minutes may be required for a gas pressure to reach a peak value since the gas-insulated lightning arrester 101, 102, 103 has been struck by lightning. During this period, the outside-air temperature may be changed. The gas pressure of the gas-insulated lightning arrester 101, 102, 103, which has not been struck by lightning, is increased due to the change of outside-air temperature. That is, the change of gas pressure of the gas-insulated lightning arrester 101, 102, 103 having been struck by lightning includes a change of gas pressure due to the change of outside-air temperature.

Thus, the effective-value calculation unit 42 calculates a change of gas pressure of the gas-insulated lightning arrester 101, 102, 103 having been struck by lightning, taking into account a change of ambient temperature of the tank 11, 21, 31, that is, a change of outside-air temperature. Specifically, the effective-value calculation unit 42 calculates an effective increase value Pr that is an effective internal value by subtracting a gas-pressure increase value Pup2 that increases from an initial pressure P02 in the gas-insulated lightning arrester 101, 102, 103 not having been struck by lightning, from a gas-pressure increase value Pup1 that increases from an initial pressure P01 in the gas-insulated lightning arrester 101, 102, 103 having been struck by lightning. The effective increase value Pr is calculated for the entire range of gas pressure stored in the storage unit 47. Thus, an effective change curve C10 is obtained, which is a difference between the gas-pressure change curve C1 of the gas-insulated lightning arrester 101, 102, 103 having been struck by lightning, and the gas-pressure change curve C2 of the gas-insulated lightning arrester 101, 102, 103 not having been struck by lightning. Subsequently, a peak value Psp of the effective gas-pressure increase value is obtained from the effective change curve C10. The obtained peak value Psp is different from a peak value Pp on a change curve illustrated in FIG. 3.

The effective-value conversion unit 43 converts the peak value Psp of the effective gas-pressure increase value to a temperature increase value within the tank 11, 21, 31 based on heat-transfer properties and the like of the tank 11, 21, 31. The energy calculation unit 44 calculates the amount of lightning strike energy based on the converted temperature increase value. The calculated amount of lightning strike energy is stored in the storage unit 47.

The determination unit 45 accumulates the previous amounts of lightning strike energy having been so far stored in the storage unit 47, and the present amount of lightning strike energy. When the cumulative amount of lightning strike energy exceeds a predetermined threshold, the determination unit 45 determines that the LA element 12, 22, 32 included in the corresponding gas-insulated lightning arrester 101, 102, 103 is degraded. The threshold to be used for the degradation determination is stored in the storage unit 47, and is derived from the capacity of the LA elements 12, 22, and 32 to withstand a cumulative energy amount and their degradation characteristics.

When the amount of currently calculated lightning strike energy exceeds a predetermined threshold, the determination unit 45 determines that the LA element 12, 22, 32 included in the corresponding gas-insulated lightning arrester 101, 102, 103 is broken. The threshold to be used for the breakage determination is stored in the storage unit 47. The threshold to be used for the breakage determination is smaller than the threshold to be used for the degradation determination.

The signal transmitting unit 46 functions as a degradation-signal transmitting unit that transmits a degradation signal when the LA element 12, 22, 32 is determined to be degraded. The degradation signal includes information indicating the LA element 12, 22, or 32 that has been determined to be degraded. The signal transmitting unit 46 also functions as a breakage-signal transmitting unit that transmits a breakage signal when the LA element 12, 22, 32 is determined to be broken. The breakage signal includes information indicating the LA element 12, 22, or 32 that has been determined to be broken.

For example, a degradation signal or a breakage signal is input to a display device (not illustrated). The display device displays information indicating degradation of the LA element 12, 22, 32 or information indicating breakage of the LA element 12, 22, 32.

Breakage of the LA element 12, 22, 32 is described below. The LA elements 12, 22, and 32 are guaranteed to withstand an amount of lightning strike energy as prescribed in their applicable standards. This prescribed withstand amount of lightning strike energy is stored in the storage unit 47 as a threshold. Each of the LA elements 12, 22, and 32 is configured by a plurality of elements connected in series. Upon occurrence of a lightning strike, the lightning strike energy is absorbed by the elements that constitute the LA element 12, 22, 32 corresponding to the phase of the gas-insulated lightning arrester having been struck by lightning.

When the lightning strike energy exceeds the threshold, while a part of the elements may be broken, the LA element 12, 22, 32 in its entirety may not be broken, and thus the operation may be resumed normally after the lightning strike. As described above, even though there is not an obvious sign of irregularities, when any one of the LA elements 12, 22, and 32 is broken, the monitoring system 100 can still determine and detect the breakage of the any one of the LA elements 12, 22, and 32.

The breakage determination performed by the monitoring system 100 indicates the possibility of breakage, but cannot certainly determine that the LA element 12, 22, 32 is broken. However, the breakage determination is performed with improved accuracy by eliminating the influence of change of outside-air temperature and calculating the amount of lightning strike energy.

As described in the first embodiment, breakage determination may be performed by comparing a calculated amount of lightning strike energy with a prescribed withstand amount of lightning strike energy. The breakage determination may also be performed by calculating a pressure increase value inversely from a prescribed withstand amount of lightning strike energy, and then comparing the pressure increase values with each other. Further, the breakage determination is performed by inversely calculating a temperature increase value at the time of a lightning strike with the prescribed withstand amount of lightning strike energy, then storing the calculated temperature increase value in the storage unit 47, and comparing the temperature increase values with each other. The same applies to degradation determination.

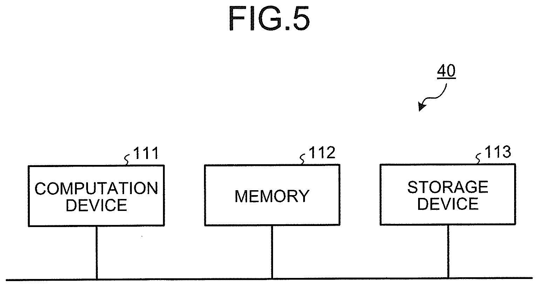

FIG. 5 is a diagram illustrating a hardware configuration of the detection device 40 according to the first embodiment. The detection device 40 includes a computation device 111 that performs computation processing such as a Central Processing Unit (CPU), a volatile memory 112 that is used as a work area by the computation device 111, and a nonvolatile storage device 113 that stores therein programs, a gas pressure, a threshold, and the like.

Individual functions of the lightning-strike detection unit 41, the effective-value calculation unit 42, the effective-value conversion unit 43, the energy calculation unit 44, the determination unit 45, and the signal transmitting unit 46, all of which are illustrated in FIG. 2, are implemented by the computation device 111 that executes programs stored in the storage device 113. The function of the storage unit 47 illustrated in FIG. 2 is implemented by the storage device 113.

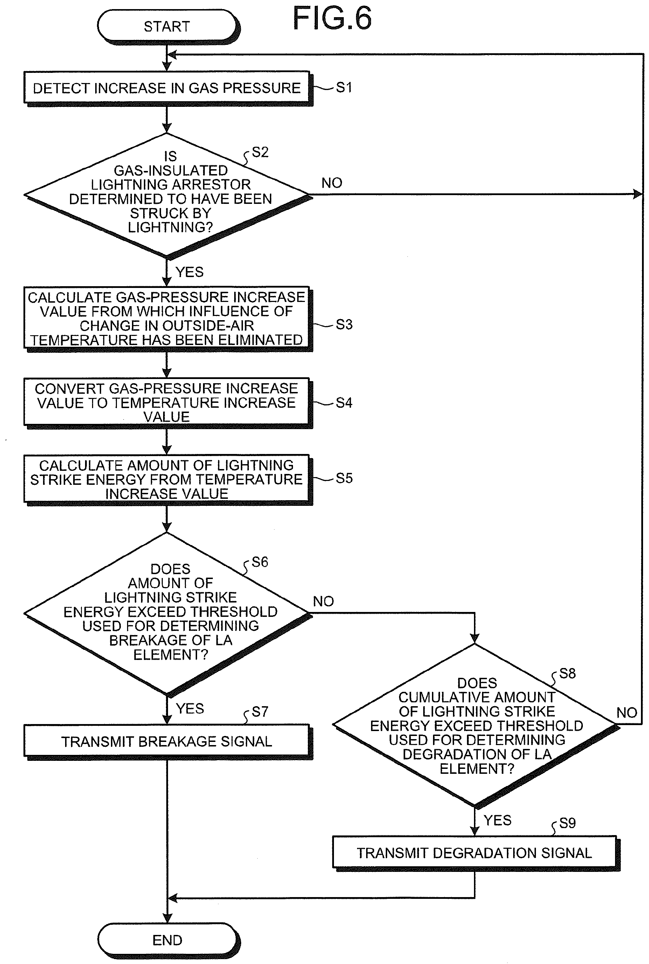

Next, a procedure for determining whether the LA element 12, 22, 32 is degraded or broken in the monitoring system 100 according to the first embodiment is described with reference to a flowchart. FIG. 6 is a flowchart illustrating the procedure for determining whether the LA element 12, 22, 32 is degraded or broken in the monitoring system 100 according to the first embodiment.

In the monitoring system 100, an increase in the gas pressure is detected (Step S1). When the gas-insulated lightning arrester101, 102, 103 is determined to have been struck by lightning based on the detected gas-pressure increase value (YES at Step S2), a gas-pressure increase value of the gas-insulated lightning arrester 101, 102, 103 determined to have been struck by lightning is calculated in which the influence of change of outside-air temperature has been eliminated (Step S3). When the gas-insulated lightning arrester 101, 102, 103 is determined not to have been struck by lightning (NO at Step S2), the process flow returns to Step S1 to continue monitoring of a lightning strike.

Next, the gas-pressure increase value is converted to a temperature increase value (Step S4). The amount of lightning strike energy is calculated from the temperature increase value (Step S5). When the amount of lightning strike energy exceeds a threshold used for determining breakage of the LA element 12, 22, 32 (YES at Step S6), a breakage signal is transmitted (Step S7).

When the amount of lightning strike energy does not exceed the threshold used for determining breakage of the LA element 12, 22, 32 (NO at Step S6), and when a cumulative amount of lightning strike energy exceeds a threshold used for determining degradation of the LA element 12, 22, 32 (YES at Step S8), then a degradation signal is transmitted (Step S9). When the cumulative amount of lightning strike energy does not exceed the threshold used for determining degradation of the LA element 12, 22, 32 (NO at Step S8), the process flow returns to Step S1 to continue monitoring of a lightning strike.

As described above, the monitoring system according to the first embodiment uses a gas-pressure increase value of the gas-insulated lightning arrester 101, 102, 103 not having been struck by lightning, to correct a gas-pressure increase value of the gas-insulated lightning arrester 101, 102, 103 having been struck by lightning. Thus, the monitoring system according to the first embodiment can calculate an actual amount of lightning strike energy from which the influence of outside-air temperature has been eliminated. By calculating the amount of lightning strike energy more accurately in the manner as described above, the monitoring system can improve the accuracy in determining degradation or breakage of the LA element 12, 22, 32. The improved accuracy in determining degradation or breakage of the LA element 12, 22, 32 can suppress occurrence of unnecessary replacement and unnecessary maintenance of the LA elements 12, 22, and 32. Thus, the maintenance cost for the gas-insulated lightning arresters 101, 102, and 103 can be reduced.

In the first embodiment, the monitoring system detects an increase in the gas pressure within the tank 11, 21, 31 by using the sensor 15, 25, 35. The monitoring system calculates a temperature increase value within the tank 11, 21, 31 based on the detected gas-pressure increase value. However, the temperature within the tank 11, 21, 31 may be directly measured by the sensor 15, 25, 35. In this case, the sensor 15, 25, 35 detects the temperature as an internal value. The effective-value conversion unit 43 calculates an effective temperature increase value as an effective internal value.

In the first embodiment, the monitoring system 100 performs both of the determination of degradation and breakage of the LA element 12, 22, 32. However, it is permissible that the monitoring system 100 is configured to perform either one of the determinations.

### Second embodiment.

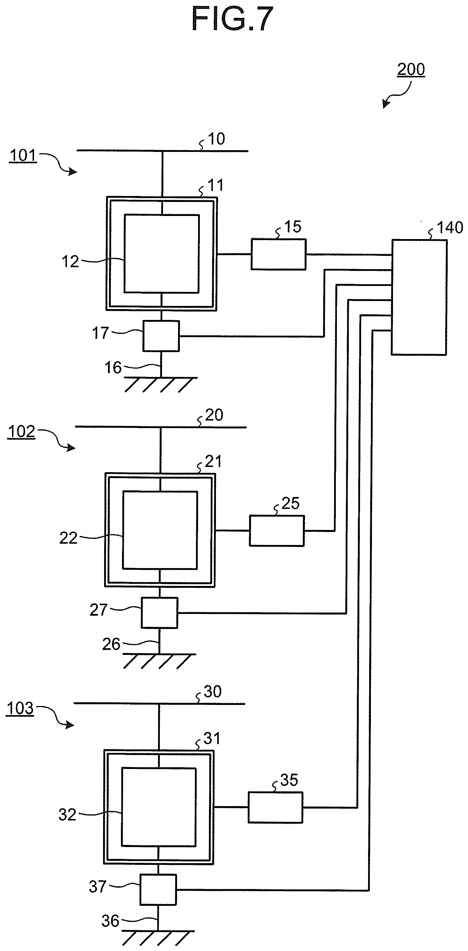

FIG. 7 is a configuration diagram of a monitoring system according to a second embodiment of the present invention. Constituent elements identical to those of the first embodiment described above are denoted by like reference signs and detailed descriptions thereof will be omitted. In a monitoring system 200 according to the second embodiment, whether a lightning strike has occurred is determined by lightning-arrester operation counters 17, 27, and 37 provided respectively on the ground wires 16, 26, and 36. Specifically, when a lightning-strike current greater than a certain setting flows through the ground wire 16, 26, 36, the lightning-arrester operation counter 17, 27, 37 detects the operation of the LA element 12, 22, 32, and outputs a signal to outside.

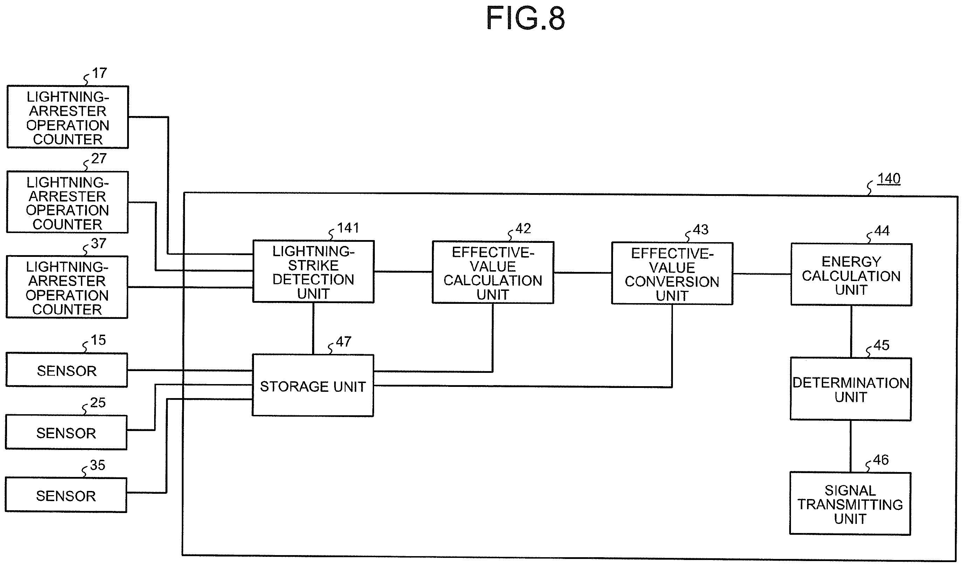

FIG. 8 is a diagram illustrating a functional configuration of a detection device 140 according to the second embodiment. In the second embodiment, the gas-insulated lightning arrester can be determined to have been struck by lightning based on a signal output from the lightning-arrester operation counter 17, 27, 37. Therefore, upon receiving a signal output from the lightning-arrester operation counter 17, 27, 37, a lightning-strike detection unit 141 outputs a signal to the effective-value calculation unit 42, and stores a gas pressure in the storage unit 47. After the gas-insulated lightning arrester is determined to have been struck by lightning, the effective-value calculation unit 42 and other units operate in the same manner as in the first embodiment. Thus, detailed descriptions thereof will be omitted. The hardware configuration of the detection device 140 is identical to that of the first embodiment and thus illustrations thereof will be omitted.

In the second embodiment, the lightning-arrester operation counter 17, 27, 37 determines whether a lightning strike has occurred based on an actual magnitude of a current that flows through the ground wire 16, 26, 36. Thus, the monitoring system can more accurately determine the time when the gas-insulated lightning arrester has been struck by lightning. Therefore, the amount of lightning strike energy can be calculated more accurately.

It is permissible that the monitoring system is configured to detect the temperature in the tank 11, 21, 31 as an internal value by the sensor 15, 25, 35.

### Third embodiment.

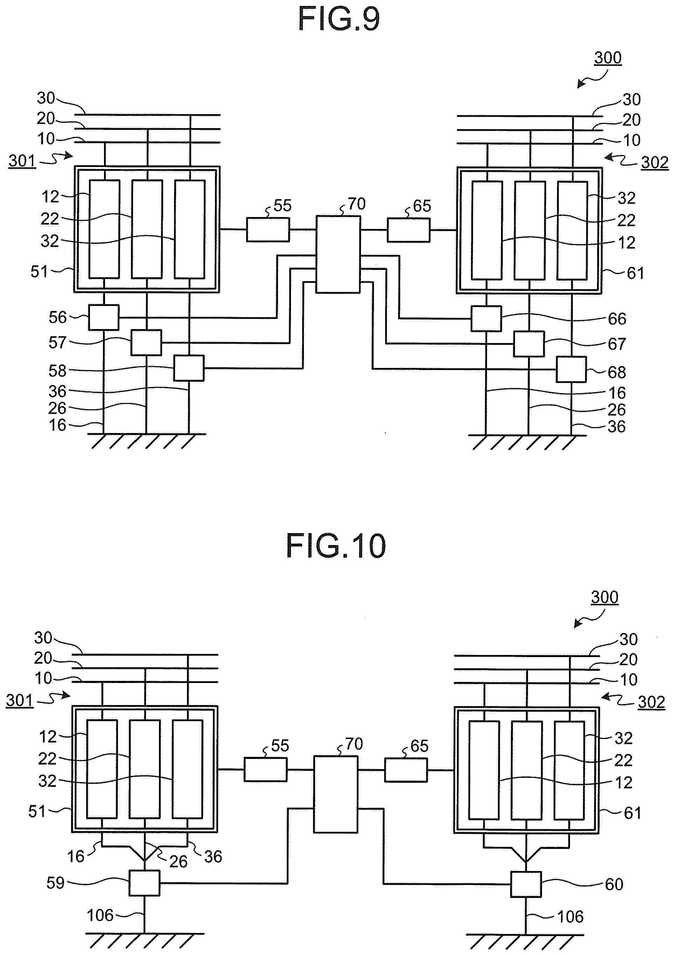

FIG. 9 is a configuration diagram of a monitoring system according to a third embodiment of the present invention. Constituent elements identical to those of the first and second embodiments described above are denoted by like reference signs and detailed descriptions thereof will be omitted. In the first and second embodiments, the monitoring system is configured to monitor the gas-insulated lightning arresters for three phases, each of which includes a separate tank. In a lower voltage class, three-phase integrated tanks 51 and 61 may be used as illustrated in FIG. 9.

In FIG. 9, each of gas-insulated lightning arresters 301 and 302 is configured by three LA elements 12, 22, and 32 located in each of the three-phase integrated tanks 51 and 61. A monitoring system 300 monitors the two gas-insulated lightning arresters 301 and 302. A sensor 55 that detects a gas pressure in the tank 51 is provided. A signal output from the sensor 55 is input to a detection device 70.

In general, a power system has two system lines. Thus, three LA elements 12, 22, and 32 are also respectively arranged in the three-phase integrated tank 61. A sensor 65 that detects a gas pressure in the tank 61 is provided. A signal output from the sensor 65 is input to the detection device 70.

Lightning-arrester operation counters 56, 57, and 58 are provided respectively on the ground wires 16, 26, and 36 extending individually from the LA elements 12, 22, and 32 arranged in the tank 51. Lightning-arrester operation counters 66, 67, and 68 are provided respectively on the ground wires 16, 26, and 36 extending individually from the LA elements 12, 22, and 32 arranged in the tank 61.

The detection device 70 has the same functional configuration as the detection device 140 illustrated in FIG. 8. Upon receiving a signal output from the lightning-arrester operation counter 56, 57, 58, 66, 67, 68, the lightning-strike detection unit 141 outputs a signal to the effective-value calculation unit 42, and stores a gas pressure in the storage unit 47. Similarly to the first and second embodiments described above, after the gas-insulated lightning arrester is determined to have been struck by lightning, the lightning-strike detection unit 141 calculates the amount of lightning strike energy from which the influence of outside-air temperature has been eliminated, by subtracting a gas-pressure increase value of the tank 51, 61 not having been struck by lightning from a gas-pressure increase value of the tank 51, 61 having been struck by lightning.

In this manner, the gas-pressure increase value of the gas-insulated lightning arrester 301, 302 having been struck by lightning is corrected even in a case where the three-phase integrated tanks 51 and 61 are used, and thereby an actual amount of lightning strike energy can still be calculated in which the influence of outside-air temperature has been eliminated. By calculating the amount of lightning strike energy more accurately in the manner as described above, the monitoring system can improve the accuracy in determining degradation or breakage of the LA element 12, 22, 32. The improved accuracy in determining degradation or breakage of the LA element 12, 22, 32 can suppress unnecessary replacement and maintenance of the LA elements 12, 22, and 32. Thus, the maintenance cost for the gas-insulated lightning arresters 301 and 302 can be reduced.

As described above in the third embodiment, even in a case where the three-phase integrated tanks 51 and 61 are used, the monitoring system may be configured to determine whether a lightning strike has occurred based on a gas pressure in the same manner as in the first embodiment described above.

The monitoring system may be configured to detect the temperature in the tank 51, 61 as an internal value by the sensor 55, 65.

FIG. 10 is a configuration diagram of the monitoring system 300 according to a modification of the third embodiment. In the present modification, the ground wires 16, 26, and 36 are combined into a single ground wire 106. A lightning-arrester operation counter 59 is provided on the ground wire 106 connecting to the tank 51. A lightning-arrester operation counter 60 is provided on the ground wire 106 connecting to the tank 61. When a lightning-strike current greater than a preset magnitude flows through the ground wire 106, the lightning-arrester operation counter 59, 60 detects the operation of the LA element 12, 22, 32, and outputs a signal to the detection device 70.

Upon receiving a signal output from the lightning-arrester operation counter 59, 60, the lightning-strike detection unit 141 outputs a signal to the effective-value calculation unit 42, and stores a gas pressure in the storage unit 47. Similarly to the first and second embodiments described above, after the gas-insulated lightning arrester is determined to have been struck by lightning, the lightning-strike detection unit 141 calculates the amount of lightning strike energy from which the influence of outside-air temperature has been eliminated, by subtracting the gas-pressure increase value of the tank 51, 61 not having been struck by lightning from the gas-pressure increase value of the tank 51, 61 having been struck by lightning.

In the present modification, only a single lightning-arrester operation counter 59, 60 is provided for three LA elements 12, 22, and 32. Thus, the monitoring system cannot determine exactly which of the LA elements 12, 22, and 32 is broken, but can determine in which tank 51 or 61, the LA element 12, 22, 32 is broken.

In FIG. 4, a change of gas pressure has been described using an example in which an outside-air temperature increases after occurrence of a lightning strike. However, it is apparent that the influence of outside-air temperature can still be eliminated even when the outside-air temperature decreases.

The gas-insulated lightning arrester has been described as an example of the intended use of the present invention. However, the present invention can also be utilized for diagnosis of degradation or breakage of other elements having degradation characteristics due to the withstand energy amount.

The configurations described in the above embodiments are only examples of the content of the present invention. The configurations can be combined with other well-known techniques, and a part of each configuration can be omitted or modified without departing from the scope of the present invention.

### Reference Signs List

10, 20, 30 high-voltage conductor, 11, 21, 31, 51, 61 tank, 12, 22, 32 lightning arrester element, 15, 25, 35, 55, 65 sensor (internal-value detection unit), 16, 26, 36, 106 ground wire, 17, 27, 37, 56, 57, 58, 59, 60, 66, 67, 68 lightning-arrester operation counter, 40, 70, 140 detection device, 41, 141 lightning-strike detection unit, 42 effective-value calculation unit, 43 effective-value conversion unit, 44 energy calculation unit, 45 determination unit, 46 signal transmitting unit, 47 storage unit, 100, 200, 300 monitoring system, 101, 102, 103, 301, 302 gas-insulated lightning arrester, 111 computation device, 112 memory, 113 storage device.

## Claims

1. A monitoring system (100, 200, 300) to monitor a plurality of gas-insulated lightning arresters (101, 102, 103, 301, 302), each of which is provided with a lightning arrester element (12, 22, 32) within a tank (11, 21, 31, 51, 61) filled with insulating gas, the monitoring system (100, 200, 300) comprising:
an internal-value detection unit (15, 25, 35, 55, 65) to detect an internal value that indicates a temperature or a pressure inside the tank (11, 21, 31, 51, 61);
a lightning-strike detection unit (41, 141) to detect that the gas-insulated lightning arrester (101, 102, 103, 301, 302) has been struck by lightning based on the detected internal value;
an effective-value calculation unit (42) to calculate an effective internal value by subtracting an internal value within a tank (11, 21, 31, 51, 61) of a gas-insulated lightning arrester (101, 102, 103, 301, 302) determined not to have been struck by lightning, among the gas-insulated lightning arresters (101, 102, 103, 301, 302), from an internal value within a tank (11, 21, 31, 51, 61) of a gas-insulated lightning arrester (101, 102, 103, 301, 302) determined to have been struck by lightning, among the gas-insulated lightning arresters (101, 102, 103, 301, 302); and
an energy calculation unit (44) to calculate an amount of lightning strike energy received by the strucked by lightning gas-insulated lightning arrester (101, 102, 103, 301, 302) from the effective internal value.

2. The monitoring system (100, 200, 300) according to claim 1, further comprising:
a degradation determination unit (45) to determine that the gas-insulated lightning arrester (101, 102, 103, 301, 302) is degraded when a cumulative amount of energy obtained by accumulating a calculated amount of lightning strike energy exceeds a threshold; and
a degradation signal transmitting unit (46) to transmit a degradation signal indicating the gas-insulated lightning arrester (101, 102, 103, 301, 302) is degraded when the gas-insulated lightning arrester (101, 102, 103, 301, 302) is determined to be degraded.

3. The monitoring system (100, 200, 300) according to claim 1, further comprising:
a breakage determination unit (45) to determine that the gas-insulated lightning arrester (101, 102, 103, 301, 302) is broken when a calculated amount of lightning strike energy exceeds a threshold; and
a breakage signal transmitting unit (46) to transmit a breakage signal indicating that the gas-insulated lightning arrester (101, 102, 103, 301, 302) is broken when the gas-insulated lightning arrester (101, 102, 103, 301, 302) is determined to be broken.

4. A monitoring method for monitoring a plurality of gas-insulated lightning arresters (101, 102, 103, 301, 302), each of which is provided with a lightning arrester element (12, 22, 32) within a tank (11, 21, 31, 51, 61) filled with insulating gas, the monitoring method comprising:
a step of detecting an internal value that indicates a temperature or a pressure inside the tank (11, 21, 31, 51, 61) ;
a step of detecting that the gas-insulated lightning arrester (101, 102, 103, 301, 302) has been struck by lightning based on the detected internal value;
a step of calculating an effective internal value by subtracting an internal value within a tank (11, 21, 31, 51, 61) of a gas-insulated lightning arrester (101, 102, 103, 301, 302) determined not to have been struck by lightning, among the gas-insulated lightning arresters (101, 102, 103, 301, 302), from an internal value within a tank (11, 21, 31, 51, 61) of a gas-insulated lightning arrester (101, 102, 103, 301, 302) determined to have been struck by lightning, among the gas-insulated lightning arresters (101, 102, 103, 301, 302); and
a step of calculating an amount of lightning strike energy received by the strucked by lightning gas-insulated lightning arrester (101, 102, 103, 301, 302) from the effective internal value.

5. The monitoring method according to claim 4, further comprising:
a step of determining that the gas-insulated lightning arrester (101, 102, 103, 301, 302) is degraded when a cumulative amount of energy obtained by accumulating a calculated amount of lightning strike energy exceeds a threshold; and
a step of transmitting a degradation signal indicating that the gas-insulated lightning arrester (101, 102, 103, 301, 302) is degraded when the gas-insulated lightning arrester (101, 102, 103, 301, 302) is determined to be degraded.

6. The monitoring method according to claim 4, further comprising:
a step of determining that the gas-insulated lightning arrester (101, 102, 103, 301, 302) is broken when a calculated amount of lightning strike energy exceeds a threshold; and
a step of transmitting a breakage signal indicating that the gas-insulated lightning arrester (101, 102, 103, 301, 302) is broken when the gas-insulated lightning arrester (101, 102, 103, 301, 302) is determined to be broken.

## Patentansprüche

1. Überwachungssystem (100, 200, 300) zum Überwachen mehrerer gasisolierter Blitzableiter (101, 102, 103, 301, 302), wovon jeder mit einem Blitzableiterelement (12, 22, 32) in einem mit Isoliergas gefüllten Behälter (11, 21, 31, 51, 61) versehen ist, wobei das Überwachungssystem (100, 200, 300) umfasst:
eine Innenwerterfassungseinheit (15, 25, 35, 55, 65) zum Erfassen eines Innenwerts, der eine Temperatur oder einen Druck im Inneren des Behälters (11, 21, 31, 51, 61) angibt;
eine Blitzeinschlagerfassungseinheit (41, 141) zum Erfassen auf Grundlage des erfassten Innenwerts, dass der gasisolierte Blitzableiter (101, 102, 103, 301, 302) von einem Blitz getroffen wurde;
eine Effektivwertberechnungseinheit (42) zum Berechnen eines effektiven Innenwerts, indem ein Innenwert in einem Behälter (11, 21, 31, 51, 61) eines gasisolierten Blitzableiters (101, 102, 103, 301, 302) von den gasisolierten Blitzableitern (101, 102, 103, 301, 302), der als nicht von einem Blitz getroffen bestimmt wird, von einem Innenwert in einem Behälter (11, 21, 31, 51, 61) eines gasisolierten Blitzableiters (101, 102, 103, 301, 302) von den gasisolierten Blitzableitern (101, 102, 103, 301, 302), der als von einem Blitz getroffen bestimmt wird, abgezogen wird; und
eine Energieberechnungseinheit (44) zum Berechnen ausgehend vom effektiven Innenwert eines Betrags der Blitzschlagenergie, die von dem vom Blitz getroffenen, gasisolierten Blitzableiter (101, 102, 103, 301, 302) aufgenommen wurde.

2. Überwachungssystem (100, 200, 300) nach Anspruch 1, darüber hinaus umfassend:
eine Beschädigungsbestimmungseinheit (45) zum Bestimmen, dass der gasisolierte Blitzableiter (101, 102, 103, 301, 302) einen Schaden genommen hat, wenn ein kumulativer Betrag an Energie, die erhalten wird, indem ein berechneter Betrag an Blitzeinschlagenergie akkumuliert wird, einen Schwellenwert übersteigt; und
eine Beschädigungssignalübertragungseinheit (46) zum Übertragen eines Beschädigungssignals, das angibt, dass der gasisolierte Blitzableiter (101, 102, 103, 301, 302) einen Schaden genommen hat, wenn der gasisolierte Blitzableiter (101, 102, 103, 301, 302) als einen Schaden genommen zu haben bestimmt wird.

3. Überwachungssystem (100, 200, 300) nach Anspruch 1, darüber hinaus umfassend:
eine Bruchbestimmungseinheit (45) zum Bestimmen, dass der gasisolierte Blitzableiter (101, 102, 103, 301, 302) zu Bruch gegangen ist, wenn ein berechneter Betrag an Blitzeinschlagenergie einen Schwellenwert übersteigt; und
eine Bruchsignalübertragungseinheit (46) zum Übertragen eines Bruchsignals, das angibt, dass der gasisolierte Blitzableiter (101, 102, 103, 301, 302) zu Bruch gegangen ist, wenn der gasisolierte Blitzableiter (101, 102, 103, 301, 302) als zu Bruch gegangen bestimmt wird.

4. Überwachungsverfahren zum Überwachen mehrerer gasisolierter Blitzableiter (101, 102, 103, 301, 302), wovon jeder mit einem Blitzableiterelement (12, 22, 32) in einem mit Isoliergas gefüllten Behälter (11, 21, 31, 51, 61) versehen ist, wobei das Überwachungsverfahren umfasst:
einen Schritt des Erfassens eines Innenwerts, der eine Temperatur oder einen Druck im Inneren des Behälters (11, 21, 31, 51, 61) angibt;
einen Schritt des Erfassens auf Grundlage des erfassten Innenwerts, dass der gasisolierte Blitzableiter (101, 102, 103, 301, 302) von einem Blitz getroffen wurde;
einen Schritt des Berechnens eines effektiven Innenwerts, indem ein Innenwert in einem Behälter (11, 21, 31, 51, 61) eines gasisolierten Blitzableiters (101, 102, 103, 301, 302) von den gasisolierten Blitzableitern (101, 102, 103, 301, 302), der als nicht von einem Blitz getroffen bestimmt wird, von einem Innenwert in einem Behälter (11, 21, 31, 51, 61) eines gasisolierten Blitzableiters (101, 102, 103, 301, 302) von den gasisolierten Blitzableitern (101, 102, 103, 301, 302), der als von einem Blitz getroffen bestimmt wird, abgezogen wird; und
einen Schritt des Berechnens ausgehend vom effektiven Innenwert eines Betrags der Blitzschlagenergie, die von dem vom Blitz getroffenen, gasisolierten Blitzableiter (101, 102, 103, 301, 302) aufgenommen wurde.

5. Überwachungsverfahren nach Anspruch 4, darüber hinaus umfassend:
einen Schritt des Bestimmens, dass der gasisolierte Blitzableiter (101, 102, 103, 301, 302) einen Schaden genommen hat, wenn ein kumulativer Betrag an Energie, die erhalten wird, indem ein berechneter Betrag an Blitzeinschlagenergie akkumuliert wird, einen Schwellenwert übersteigt; und
einen Schritt des Übertragens eines Beschädigungssignals, das angibt, dass der gasisolierte Blitzableiter (101, 102, 103, 301, 302) einen Schaden genommen hat, wenn der gasisolierte Blitzableiter (101, 102, 103, 301, 302) als einen Schaden genommen zu haben bestimmt wird.

6. Überwachungsverfahren nach Anspruch 4, darüber hinaus umfassend:
einen Schritt des Bestimmens, dass der gasisolierte Blitzableiter (101, 102, 103, 301, 302) zu Bruch gegangen ist, wenn ein berechneter Betrag an Blitzeinschlagenergie einen Schwellenwert übersteigt; und
einen Schritt des Übertragens eines Bruchsignals, das angibt, dass der gasisolierte Blitzableiter (101, 102, 103, 301, 302) zu Bruch gegangen ist, wenn der gasisolierte Blitzableiter (101, 102, 103, 301, 302) als zu Bruch gegangen bestimmt wird.

## Revendications

1. Système de surveillance (100, 200, 300) destiné à surveiller une pluralité de parafoudres à isolation gazeuse (101, 102, 103, 301, 302), dont chacun est pourvu d'un élément de parafoudre (12, 22, 32) à l'intérieur d'un réservoir (11, 21, 31, 51, 61) rempli de gaz isolant, le système de surveillance (100, 200, 300) comprenant :
une unité de détection de valeur interne (15, 25, 35, 55, 65) pour détecter une valeur interne qui indique une température ou une pression à l'intérieur du réservoir (11, 21, 31, 51, 61) ;
une unité de détection de foudroiement (41, 141) pour détecter que le parafoudre à isolation gazeuse (101, 102, 103, 301, 302) a été frappé par une foudre sur la base de la valeur interne détectée ;
une unité de calcul de valeur effective (42) pour calculer une valeur interne effective en soustrayant une valeur interne à l'intérieur d'un réservoir (11, 21, 31, 51, 61) d'un parafoudre à isolation gazeuse (101, 102, 103, 301, 302) parmi les parafoudres à isolation gazeuse (101, 102, 103, 301, 302) déterminé ne pas avoir été frappé par une foudre d'une valeur interne à l'intérieur d'un réservoir (11, 21, 31, 51, 61) d'un parafoudre à isolation gazeuse (101, 102, 103, 301, 302) parmi les parafoudres à isolation gazeuse (101, 102, 103, 301, 302) déterminé avoir été frappé par une foudre; et
une unité de calcul d'énergie (44) pour calculer une quantité d'énergie de foudroiement reçue par le parafoudre à isolation gazeuse (101, 102, 103, 301, 302) frappé par une foudre à partir de la valeur interne effective.

2. Le système de surveillance (100, 200, 300) selon la revendication 1, comprenant en outre :
une unité de détermination de dégradation (45) pour déterminer que le parafoudre à isolation gazeuse (101, 102, 103, 301, 302) est dégradé lorsqu'une quantité cumulative d'énergie obtenue en accumulant une quantité calculée d'énergie de foudroiement dépasse un seuil ; et
une unité de transmission de signal de dégradation (46) pour transmettre un signal de dégradation indiquant que le parafoudre à isolation gazeuse (101, 102, 103, 301, 302) est dégradé lorsque le parafoudre à isolation gazeuse (101, 102, 103, 301, 302) est déterminé être dégradé.

3. Le système de surveillance (100, 200, 300) selon la revendication 1, comprenant en outre :
une unité de détermination de casse (45) pour déterminer que le parafoudre à isolation gazeuse (101, 102, 103, 301, 302) est cassé lorsqu'une quantité calculée d'énergie de foudroiement dépasse un seuil ; et
une unité de transmission de signal de casse (46) pour transmettre un signal de casse indiquant que le parafoudre à isolation gazeuse (101, 102, 103, 301, 302) est cassé lorsque le parafoudre à isolation gazeuse (101, 102, 103, 301, 302) est déterminé être cassé.

4. Procédé de surveillance destiné à surveiller une pluralité de parafoudres à isolation gazeuse (101, 102, 103, 301, 302), dont chacun est pourvu d'un élément de parafoudre (12, 22, 32) à l'intérieur d'un réservoir (11, 21, 31, 51, 61) rempli de gaz isolant, le procédé de surveillance comprenant :
une étape consistant à détecter une valeur interne qui indique une température ou une pression à l'intérieur du réservoir (11, 21, 31, 51, 61) ;
une étape consistant à calculer une valeur interne effective en soustrayant une valeur interne à l'intérieur d'un réservoir (11, 21, 31, 51, 61) d'un parafoudre à isolation gazeuse (101, 102, 103, 301, 302) parmi les parafoudres à isolation gazeuse (101, 102, 103, 301, 302) déterminé ne pas avoir été frappé par une foudre d'une valeur interne à l'intérieur d'un réservoir (11, 21, 31, 51, 61) d'un parafoudre à isolation gazeuse (101, 102, 103, 301, 302) parmi les parafoudres à isolation gazeuse (101, 102, 103, 301, 302) déterminé avoir été frappé par une foudre ; et
une étape consistant à calculer une quantité d'énergie de foudroiement reçue par le parafoudre à isolation gazeuse (101, 102, 103, 301, 302) frappé par une foudre à partir de la valeur interne effective.

5. Le procédé de surveillance selon la revendication 4, comprenant en outre :
une étape consistant à déterminer que le parafoudre à isolation gazeuse (101, 102, 103, 301, 302) est dégradé lorsqu'une quantité cumulative d'énergie obtenue en accumulant une quantité calculée d'énergie de foudroiement dépasse un seuil ; et
une étape consistant à transmettre un signal de dégradation indiquant que le parafoudre à isolation gazeuse (101, 102, 103, 301, 302) est dégradé lorsque le parafoudre à isolation gazeuse (101, 102, 103, 301, 302) est déterminé être dégradé.

6. Le procédé de surveillance selon la revendication 4, comprenant en outre :
une étape consistant à déterminer que le parafoudre à isolation gazeuse (101, 102, 103, 301, 302) est cassé lorsqu'une quantité calculée d'énergie de foudroiement dépasse un seuil ; et
une étape consistant à transmettre un signal de casse indiquant que le parafoudre à isolation gazeuse (101, 102, 103, 301, 302) est cassé lorsque le parafoudre à isolation gazeuse (101, 102, 103, 301, 302) est déterminé être cassé.
